# EUROPEAN PATENT APPLICATION

(11) **EP 4 155 663 A1**
(43) Date of publication of application: **29.03.2023**
(21) Application number: 21808067.9
(22) Date of filing: 14.04.2021
(51) Int. Cl.: G01C 3/06, G02B 5/00, H01S 5/0239, H01S 5/183

(54) **ELECTRONIC DEVICE**

(30) Priority: 21.05.2020 JP 2020088857
(71) Applicant: Sony Semiconductor Solutions Corporation, Atsugi-shi, Kanagawa 243-0014 (JP)
(72) Inventor: SUZUKI Daisuke, Atsugi-shi, Kanagawa 243-0014 (JP); MASUDA Takashi, Atsugi-shi, Kanagawa 243-0014 (JP); SAEKI Shinichirou, Atsugi-shi, Kanagawa 243-0014 (JP); OKAMOTO Koichi, Atsugi-shi, Kanagawa 243-0014 (JP); KIMURA Motoi, Atsugi-shi, Kanagawa 243-0014 (JP); HAMAGUCHI Yuichi, Atsugi-shi, Kanagawa 243-0014 (JP); BANNO Noriyuki, Atsugi-shi, Kanagawa 243-0014 (JP); HOSHI Mitsunari, Atsugi-shi, Kanagawa 243-0014 (JP); TAKAYAMA Akinori, Atsugi-shi, Kanagawa 243-0014 (JP); OCHIAI Soichi, Atsugi-shi, Kanagawa 243-0014 (JP); KUSUNOKI Shinichiro, Atsugi-shi, Kanagawa 243-0014 (JP); AKETO Makoto, Atsugi-shi, Kanagawa 243-0014 (JP); NODA Hideki, Atsugi-shi, Kanagawa 243-0014 (JP); SAKOH Takashi, Atsugi-shi, Kanagawa 243-0014 (JP)
(74) Representative: MFG Patentanwälte Meyer-Wildhagen Meggle-Freund Gerhard PartG mbB
(86) International application number: PCT/JP2021/015492
(87) International publication number: WO 2021/235143

(57) **Abstract**

Provided is an electronic device capable of reducing the possibility of malfunction. An electronic device is provided with: a first substrate including a drive circuit; a second substrate including a light-emitting unit driven by the drive circuit and mounted on one surface side of the first substrate; and a light-shielding unit provided on the first substrate and configured to shield at least a part of the drive circuit from light emitted by the light-emitting unit.

## Description

### TECHNICAL FIELD

The present disclosure relates to an electronic device.

### BACKGROUND ART

As a type of semiconductor laser, a surface-emitting laser such as a vertical-cavity surface-emitting laser (VCSEL) is known (e.g., see Patent Documents 1 and 2.). In general, in a light-emitting device using a surface-emitting laser, a plurality of light-emitting elements is provided in a two-dimensional array on the front surface or back surface of a substrate, and a lens is disposed thereon. The light emitted from the plurality of light-emitting elements is emitted to the outside of the light-emitting device through the lens.

### CITATION LIST

### PATENT DOCUMENT

Patent Document 1: Japanese Unexamined Patent Application Publication (Translation of PCT Application) No. 2004-526194
Patent Document 2: Japanese Patent Application Laid-Open No. 2020-20680

### SUMMARY OF THE INVENTION

### PROBLEMS TO BE SOLVED BY THE INVENTION

Fig. 7A of Patent Document 2 discloses a configuration in which a chip having a circuit as a light-emitting unit formed therein is flip chip-mounted on a chip in which a circuit as a drive unit is formed. In the device having this configuration, there is a possibility that a part of the light emitted from the light-emitting unit is reflected by the surface of the lens and incident on the drive unit. The drive unit has elements (e.g., bipolar transistors) each including a p-n junction surface. When light strikes these elements, a photovoltaic effect occurs, the characteristics of the elements change, and there is a possibility that the drive unit malfunctions.

The present disclosure has been made in view of such circumstances, and an object of the present disclosure is to provide an electronic device capable of reducing the possibility of malfunction.

### SOLUTIONS TO PROBLEMS

An electronic device according to one aspect of the present disclosure is provided with: a first substrate including a drive circuit; a second substrate including a light-emitting unit driven by the drive circuit and mounted on one surface side of the first substrate; and a light-shielding unit provided on the first substrate and configured to shield at least a part of the drive circuit from light emitted by the light-emitting unit.

Accordingly, even in a case where a part of the light (e.g., infrared light) emitted from the light-emitting unit is reflected by the surface of the lens and directed to a part of the drive circuit (e.g., a bias circuit), this infrared ray is shielded by the light-shielding unit. The light-shielding unit can reduce the occurrence of a photovoltaic effect on a p-n junction surface of an element (e.g., bipolar transistor, etc.) included in the bias circuit and can reduce a change in characteristics of the element due to the photovoltaic effect. Thus, the light-shielding unit can reduce the possibility that the drive circuit malfunctions.

An electronic device according to another aspect of the present disclosure is provided with: a first substrate including a drive circuit; a second substrate including a light-emitting unit driven by the drive circuit and mounted on one surface side of the first substrate; and a peripheral light-shielding unit having a light-shielding property against light emitted by the light-emitting unit. The first substrate includes a wire bonding pad electrode provided on one surface side of the first substrate, and a protective film provided on one surface side of the first substrate and provided with an opening that exposes the surface of the wire bonding pad electrode. The peripheral light-shielding unit is disposed around the wire bonding pad electrode.

Accordingly, even in a case where a part of light (e.g., infrared light) emitted from the light-emitting unit is reflected by the surface of the lens and directed to the periphery of the wire bonding electrode, this infrared ray is shielded by the peripheral light-shielding unit. As a result, the peripheral light-shielding unit can reduce the entry of light into the first substrate from the periphery of the wire bonding electrode. Thus, the peripheral light-shielding unit can reduce the possibility that the drive circuit malfunctions.

### BRIEF DESCRIPTION OF DRAWINGS

Fig. 1 is a block diagram illustrating a configuration example of a distance measuring device according to a first embodiment of the present disclosure.
Fig. 2 is a cross-sectional view illustrating a structural example of the distance measuring device according to the first embodiment of the present disclosure.
Fig. 3 is a block diagram illustrating a configuration example of a drive circuit according to the first embodiment of the present disclosure.
Fig. 4 is a cross-sectional view illustrating a structural example of a VCSEL mounted body according to the first embodiment of the present disclosure.
Fig. 5 is a cross-sectional view illustrating a configuration example of a VCSEL mounted body according to Modification 1 of the first embodiment of the present disclosure.
Fig. 6 is a cross-sectional view illustrating a configuration example of a VCSEL mounted body according to Modification 2 of the first embodiment of the present disclosure.
Fig. 7 is a cross-sectional view illustrating a configuration example of a VCSEL mounted body according to Modification 3 of the first embodiment of the present disclosure.
Fig. 8A is a cross-sectional view illustrating a configuration example of a VCSEL mounted body according to Modification 4A of the first embodiment of the present disclosure.
Fig. 8B is a cross-sectional view illustrating a configuration example of a VCSEL mounted body according to Modification 4B of the first embodiment of the present disclosure.
Fig. 9A is a cross-sectional view illustrating a configuration example of a VCSEL mounted body according to Modification 5A of the first embodiment of the present disclosure.
Fig. 9B is a cross-sectional view illustrating a configuration example of a VCSEL mounted body according to Modification 5B of the first embodiment of the present disclosure.
Fig. 10 is a plan view illustrating a structural example of a VCSEL mounted body according to a second embodiment of the present disclosure.
Fig. 11 is an enlarged plan view illustrating a wire bonding (WB) pad electrode and its peripheral portion illustrated in Fig. 10.
Fig. 12 is a cross-sectional view illustrating a configuration example of a VCSEL mounted body according to the second embodiment of the present disclosure.
Fig. 13 is a cross-sectional view illustrating Configuration Example 1 of the VCSEL mounted body according to a third embodiment of the present disclosure.
Fig. 14 is a cross-sectional view illustrating Configuration Example 2 of the VCSEL mounted body according to the third embodiment of the present disclosure.
Fig. 15 is a cross-sectional view illustrating Configuration Example 3 of the VCSEL mounted body according to the third embodiment of the present disclosure.
Fig. 16 is a cross-sectional view illustrating Configuration Example 1 of the VCSEL mounted body according to a fourth embodiment of the present disclosure.
Fig. 17 is an enlarged plan view illustrating a WB pad electrode and its peripheral portion illustrated in Fig. 16.
Fig. 18 is a plan view illustrating a modification of the placement of an opaque member.
Fig. 19 is a cross-sectional view illustrating Configuration Example 2 of the VCSEL mounted body according to the fourth embodiment of the present disclosure.
Fig. 20 is a cross-sectional view illustrating Configuration Example 3 of the VCSEL mounted body according to the fourth embodiment of the present disclosure.
Fig. 21 is a cross-sectional view illustrating Configuration Example 4 of the VCSEL mounted body according to the fourth embodiment of the present disclosure.

### MODE FOR CARRYING OUT THE INVENTION

Hereinafter, a first embodiment of the present disclosure will be described with reference to the drawings. In the description of the drawings referred to in the following description, the same or similar parts are denoted by the same or similar reference numerals. However, it should be noted that the drawings are schematic, and the relationship between the thickness and the plane dimension, the ratio of the thickness of each layer, and the like are different from actual ones. Therefore, specific thicknesses and dimensions should be determined in consideration of the following description. In addition, it is needless to say that portions having different dimensional relationships and ratios are included between the drawings.

The definition of directions, such as upper and lower, in the following description is merely a definition for convenience of description and does not limit the technical idea of the present disclosure. For example, it is a matter of course that when an object is rotated by 90 ° and observed, the upper and lower sides are converted to the left and right and read, and when the object is rotated by 180 ° and observed, the upper and lower parts are inverted and read.

In the following description, there are cases where the direction is described using words in the X-axis direction, the Y-axis direction, and the Z-axis direction. For example, the X-axis direction and the Y-axis direction are directions parallel to an upper surface 42a of a laser diode driver (LDD) substrate 42. The X-axis direction and the Y-axis direction are also referred to as horizontal directions. The Z-axis direction is a direction vertical to the upper surface 42a. The X-axis direction, the Y-axis direction, and the Z-axis direction are orthogonal to each other.

### <First Embodiment>

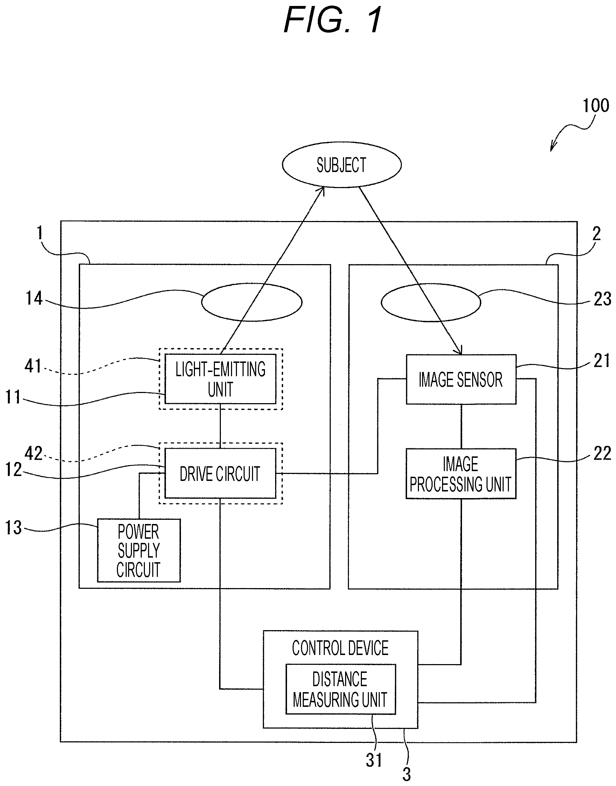

Fig. 1 is a block diagram illustrating a configuration example of a distance measuring device 100 according to a first embodiment of the present disclosure. As illustrated in Fig. 1, the distance measuring device 100 according to a first embodiment of the present disclosure (an example of an "electronic device" of the present disclosure) includes a light-emitting device 1, an imaging device 2, and a control device 3. The distance measuring device 100 irradiates a subject with light emitted from the light-emitting device 1, receives the light reflected by the subject by the imaging device 2 to image the subject, and measures (calculates) a distance to the subject by the control device 3 using an image signal output from the imaging device 2. The light-emitting device 1 functions as a light source for the imaging device 2 to image the subject.

The light-emitting device 1 includes a light-emitting unit 11, a drive circuit 12, a power supply circuit 13, and a light-emitting-side optical system 14. The imaging device 2 includes an image sensor 21, an image processing unit 22, and an imaging-side optical system 23. The control device 3 includes a distance measuring unit 31.

The light-emitting unit 11 emits laser light for irradiating the subject. The light-emitting unit 11 includes a VCSEL. For example, the light-emitting unit 11 includes a plurality of light-emitting elements arranged in a two-dimensional array, and each light-emitting element has a VCSEL structure. The subject is irradiated with light emitted from these light-emitting elements. The light emitted from the light-emitting element is, for example, infrared light. The light-emitting unit 11 is provided in a chip called a laser diode (LD) chip 41.

The drive circuit 12 is an electric circuit that drives the light-emitting unit 11. The power supply circuit 13 is an electric circuit that generates the power supply voltage of the drive circuit 12. For example, the distance measuring device 100 generates a power supply voltage from an input voltage supplied from a battery (not illustrated) by the power supply circuit 13, supplies the generated power supply voltage to the drive circuit 12, and drives the light-emitting unit 11 by the drive circuit 12. The battery may be provided inside the distance measuring device 100 or may be provided outside the distance measuring device 100. Further, the drive circuit 12 is provided in a substrate called a laser diode driver (LDD) substrate 42.

The light-emitting-side optical system 14 includes various optical elements and irradiates the subject with light from the light-emitting unit 11 via these optical elements. Similarly, the imaging-side optical system 23 includes various optical elements and receives light from the subject via these optical elements.

The image sensor 21 receives light from the subject via the imaging-side optical system 23 and converts the light into an electric signal by photoelectric conversion. The image sensor 21 is, for example, a charge-coupled device (CCD) sensor or a complementary metal-oxide-semiconductor (CMOS) sensor. The image sensor 21 converts the electronic signal described above from an analog signal to a digital signal by analog-to-digital (A/D) conversion and outputs an image signal as a digital signal to the image processing unit 22. Further, the image sensor 21 outputs a frame synchronization signal to the drive circuit 12, and on the basis of the frame synchronization signal, the drive circuit 12 causes the light-emitting unit 11 to emit light at a timing corresponding to a frame period in the image sensor 21.

The image processing unit 22 performs various types of image processing on the image signal output from the image sensor 21. The image processing unit 22 includes, for example, an image processing processor such as a digital signal processor (DSP).

The control device 3 controls various operations of the distance measuring device 100 and controls, for example, a light-emitting operation of the light-emitting device 1 and an imaging operation of the imaging device 2. The control device 3 includes, for example, a central processing unit (CPU), a read-only memory (ROM), a random-access memory (RAM), and the like.

The distance measuring unit 31 measures the distance to the subject on the basis of the image signal output from the image sensor 21 and subjected to the image processing by the image processing unit 22. The distance measuring unit 31 adopts, for example, a structured light (STL) system or a time of flight (ToF) system as a distance measuring system. Moreover, the distance measuring unit 31 may further measure the distance between the distance measuring device 100 and the subject for each portion of the subject on the basis of the image signal described above to specify the three-dimensional shape of the subject.

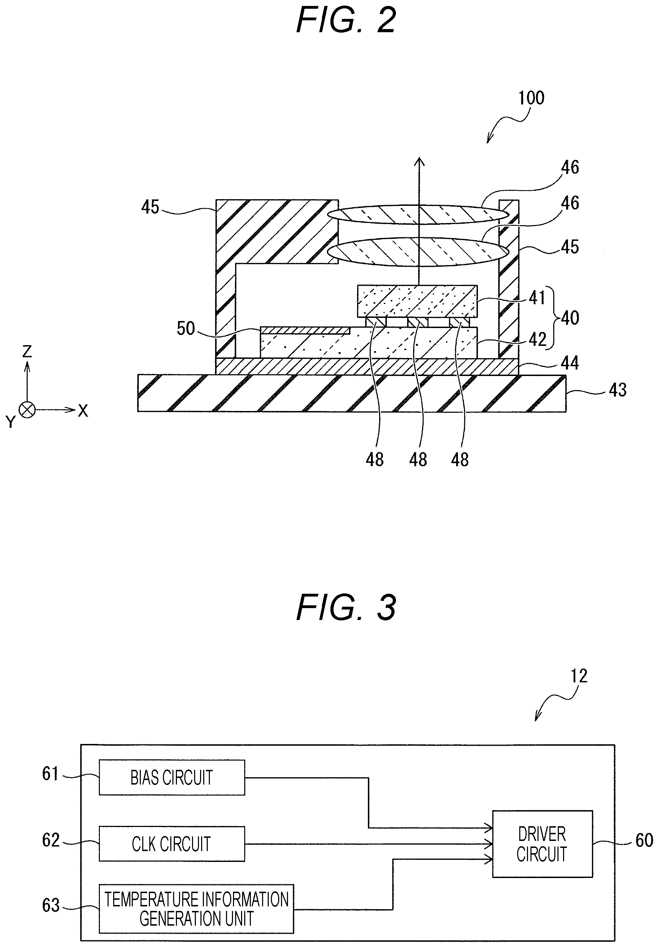

Fig. 2 is a cross-sectional view illustrating a structural example of the distance measuring device 100 according to the first embodiment of the present disclosure. As illustrated in Fig. 2, the distance measuring device 100 includes the LD chip 41 (an example of a "second substrate" of the present disclosure) and the LDD substrate 42 (an example of a "first substrate" of the present disclosure) described above, a mounting substrate 43, a heat dissipation substrate 44, a correction lens holder 45, one or more correction lenses 46 (an example of a "lens" of the present disclosure), and a plurality of bump electrodes 48. Note that in Fig. 2, the X-axis direction and the Y-axis direction correspond to the horizontal direction, and the Z-axis direction corresponds to the vertical direction. Further, the arrow direction of the Z axis corresponds to the upward direction, and the opposite of the arrow direction corresponds to the downward direction.

As illustrated in Fig. 2, the LDD substrate 42 is disposed on the mounting substrate 43 via the heat dissipation substrate 44. Further, an LD chip 41 is disposed on the LDD substrate 42. For example, the LD chip 41 is flip chip-mounted on the LDD substrate 42. The mounting substrate 43 is, for example, a printed board. The mounting substrate 43 is provided with the image sensor 21 and the image processing unit 22 illustrated in Fig. 1. The heat dissipation substrate 44 is, for example, a ceramic substrate such as an aluminum nitride (AlN) substrate.

The correction lens holder 45 is disposed on the heat dissipation substrate 44 so as to surround the LD chip 41, and holds one or more correction lenses 46 above the LD chip 41. These correction lenses 46 are included in the light-emitting-side optical system 14 described above (cf. Fig. 1). The correction lenses 46 are disposed at a position facing the LDD substrate 42 across the LD chip 41. Light emitted from the light-emitting unit 11 (cf. Fig. 1) in the LD chip 41 is incident on and corrected by these correction lenses 46, and the subject is then irradiated with the light (cf. Fig. 1). Fig. 2 illustrates two correction lenses 46 held by correction lens holder 45 as an example of the first embodiment.

The plurality of bump electrodes 48 is provided on at least one of the upper surface of the LDD substrate 42 or the lower surface of the LD chip 41 and electrically connects the LDD substrate 42 and the LD chip 41. The bump electrode 48 is made of an arbitrary metal material such as gold (Au), nickel (Ni), or aluminum (Al).

Furthermore, the LDD substrate 42 is provided with a light-shielding film 50 (an example of a "light-shielding unit" of the present disclosure) that shields at least a part of the drive circuit 12 from light emitted by the light-emitting unit 11 provided in the LD chip 41. The light-shielding film 50 may be provided on the upper surface 42a of the LDD substrate 42 or may be provided inside the LDD substrate 42.

In the first embodiment of the present disclosure, a structural body in which the LD chip 41 including the VCSEL is flip chip-mounted on the LDD substrate 42 is referred to as a VCSEL mounted body 40.

Fig. 3 is a block diagram illustrating a configuration example of the drive circuit 12 according to the first embodiment of the present disclosure. As illustrated in Fig. 3, the drive circuit 12 includes a driver circuit 60 that drives the light-emitting unit 11 (cf. Fig. 1), a bias circuit 61, a clock (CLK) circuit 62, and a temperature information generation unit 63. The bias circuit 61 generates a reference current from the power supply voltage supplied from the power supply circuit 13 and supplies the generated reference current to the driver circuit 60. The CLK circuit 62 generates a clock signal for controlling the light emission timing of the light-emitting unit 11 and supplies the generated clock signal to the driver circuit 60. The temperature information generation unit 63 measures the temperature of the LDD substrate 42, generates a signal including temperature information, and supplies the generated signal to the driver circuit 60. As illustrated in Fig. 2, since the LD chip 41 is flip chip-mounted on the LDD substrate 42, the temperature of the LDD substrate 42 is correlated with the temperature of the LD chip 41.

The driver circuit 60 controls the light emission timing of the light-emitting unit 11 on the basis of the supplied clock signal. In addition, the driver circuit 60 corrects a current value to be applied to the light-emitting unit 11 on the basis of the signal supplied from the temperature information generation unit 63. As a result, the driver circuit 60 can reduce the fluctuation of the intensity of the light emitted from the light-emitting unit 11 due to the temperature.

### (Specific Examples)

Next, the structure of the VCSEL mounted body 40 in which the LD chip 41 is flip chip-mounted on the LDD substrate 42 will be described more specifically.

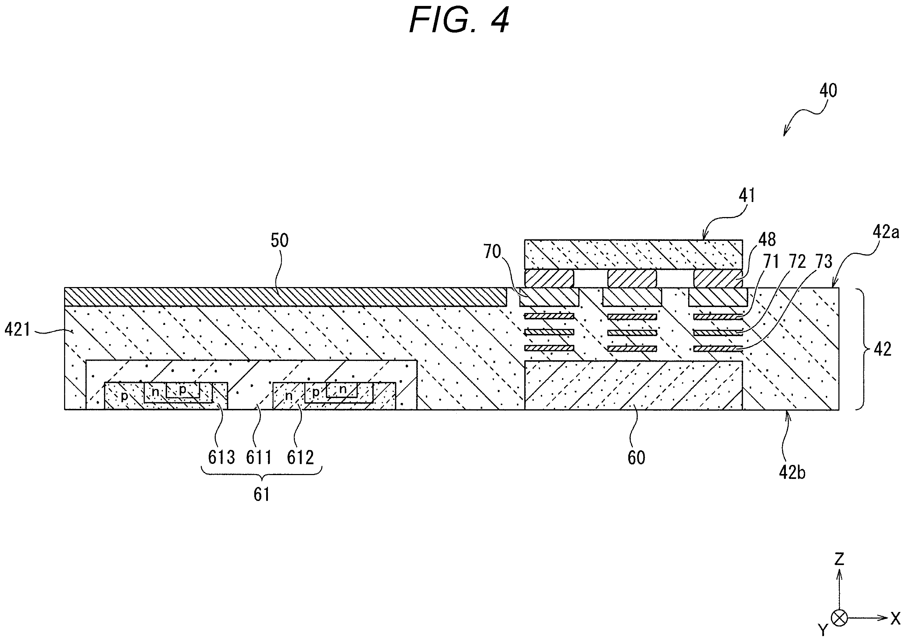

Fig. 4 is a cross-sectional view illustrating a structural example of the VCSEL mounted body 40 according to the first embodiment of the present disclosure. As illustrated in Fig. 4, the VCSEL mounted body 40 includes the LDD substrate 42, the LD chip 41, and the bump electrode 48 electrically connecting the LDD substrate 42 and the LD chip 41. The LDD substrate 42 has the upper surface 42a (an example of "one surface" of the present disclosure) and a lower surface 42b, and the LD chip 41 is flip chip-mounted on the upper surface 42a side via the bump electrode 48.

The LDD substrate 42 has a substrate body 421 made of Si, for example. The upper surface 42a of the LDD substrate 42 is an upper surface of the substrate body 421, and a lower surface 42b of the LDD substrate 42 is a lower surface of the substrate body 421. The substrate body 421 includes the driver circuit 60, the bias circuit 61, the CLK circuit 62 (cf. Fig. 3), and the temperature information generation unit 63 (cf. Fig. 3). For example, the driver circuit 60 and the bias circuit 61 are provided on the lower surface 42b side of the substrate body 421. The driver circuit 60 and the bias circuit 61 are electrically connected to each other via a wiring layer (or at least a part of wiring layers 71 to 73 to be described later) (not illustrated).

The bias circuit 61 includes a well layer 611, an npn bipolar transistor 612 provided in the well layer 611, and a pnp bipolar transistor 613 provided in the well layer 611.

Further, the substrate body 421 is provided with the light-shielding film 50, a pad electrode 70, and a plurality of wiring layers 71 to 73. For example, the light-shielding film 50 and the pad electrode 70 are provided on the upper surface 42a of the substrate body 421. The wiring layers 71 to 73 are provided inside the substrate body 421. The pad electrode 70 is located above the driver circuit 60, and the plurality of wiring layers 71 to 73 is provided between the driver circuit 60 and the pad electrode 70. The driver circuit 60 and the pad electrode 70 are electrically connected to each other via the plurality of wiring layers 71 to 73 and a through electrode (not illustrated) that connects the wiring layers 71 to 73 in the vertical direction (Z-axis direction).

The light-shielding film 50 is made of a metal having a light-shielding property against infrared light, such as aluminum (Al) or copper (Cu). The light-shielding film 50 covers the entire region of the bias circuit 61 from the upper surface 42a side of the substrate body 421. The light-shielding film 50 may be provided on the same layer as the pad electrode 70 as illustrated in Fig. 4 or may be provided on a layer different from the pad electrode 70. In a case where the light-shielding film 50 is provided on the same layer as the pad electrode 70, the light-shielding film 50 and the pad electrode 70 may be simultaneously formed in the same process.

The bump electrode 48 is provided on the pad electrode 70. The driver circuit 60 is electrically connected to the LD chip 41 via the plurality of wiring layers 71 to 73, the pad electrode 70, and the bump electrode 48. The correction lens 46 (cf. Fig. 2) is disposed above the LD chip 41.

### (Effects of First Embodiment)

As described above, the distance measuring device 100 according to the first embodiment of the present disclosure includes the LDD substrate 42 having the drive circuit 12, the LD chip 41 having the light-emitting unit 11 driven by the drive circuit 12, and the light-shielding film 50. The LD chip 41 is flip chip-mounted on the upper surface 42a side of the LDD substrate 42. The light-shielding film 50 is provided on the LDD substrate 42 and shields at least a part of the drive circuit 12 (e.g., bias circuit 61) from light (e.g., infrared light) emitted by the light-emitting unit 10.

Accordingly, even in a case where a part of the infrared light emitted from the light-emitting unit 10 is reflected by the surface of the correction lens 46 and directed to the bias circuit 61, this infrared light is shielded by the light-shielding film 50. Even in a state where the LD chip 41 is flip chip-mounted on the upper surface 42a of the LDD substrate 42 and the upper portion of the bias circuit 61 is not sealed with a molding resin or the like (i.e., a bare state), the light-shielding film 50 prevents the incidence of infrared light on the bias circuit 61. The light-shielding film 50 can reduce the occurrence of a photovoltaic effect on the p-n junction surface of the element, such as the bipolar transistors 612, 613, included in the bias circuit 61 and can reduce a change in characteristics of the element due to the photovoltaic effect. Thus, the light-shielding film 50 can reduce the possibility that the drive circuit 12 malfunctions.

Among the circuits in the drive circuit 12, the bias circuit 61 has the highest sensitivity to light and the largest area. Therefore, in the first embodiment of the present disclosure, it is particularly preferable to shield the bias circuit 61 from light. As described above, the bias circuit 61 generates a reference current, but when the bias circuit 61 is irradiated with infrared light, the characteristics of the elements, such as the bipolar transistors 612, 613, change due to the photovoltaic effect, and the reference current fluctuates. When the fluctuation of the reference current is large, the drive circuit 12 is likely to malfunction. By shielding the bias circuit 61 from light, it is possible to reduce the fluctuation of the reference current and to reduce the possibility that the drive circuit 12 malfunctions.

### (Modification 1)

In the first embodiment described above, an aspect has been described in which the light-shielding film 50 is disposed in the region overlapping with the bias circuit 61 in the thickness direction (e.g., in the Z-axis direction) of the LDD substrate 42, and the bias circuit 61 is not disposed in the other regions. However, the first embodiment of the present disclosure is not limited thereto. In the first embodiment of the present disclosure, in the Z-axis direction, the light-shielding film 50 may be disposed in a region overlapping with the driver circuit 60 (cf. Fig. 3), the light-shielding film 50 may be disposed in a region overlapping with the CLK circuit 62 (cf. Fig. 3), or the light-shielding film 50 may be disposed in a region overlapping with the temperature information generation unit 63 (cf. Fig. 3). Hence the light-shielding film 50 can prevent the incidence of infrared light on the driver circuit 60, the CLK circuit 62, and the temperature information generation unit 63.

Any of the driver circuit 60, the CLK circuit 62, and the temperature information generation unit 63 includes an element including a p-n junction surface, such as a bipolar transistor or a MOS transistor, but the light-shielding film 50 can reduce the generation of the photovoltaic effect on the p-n junction surface by preventing the incidence of infrared light. As a result, the light-shielding film 50 can reduce a change in the characteristics of the element due to the photovoltaic effect in any of the driver circuit 60, the CLK circuit 62, and the temperature information generation unit 63 and can reduce the possibility that the drive circuit 12 malfunctions.

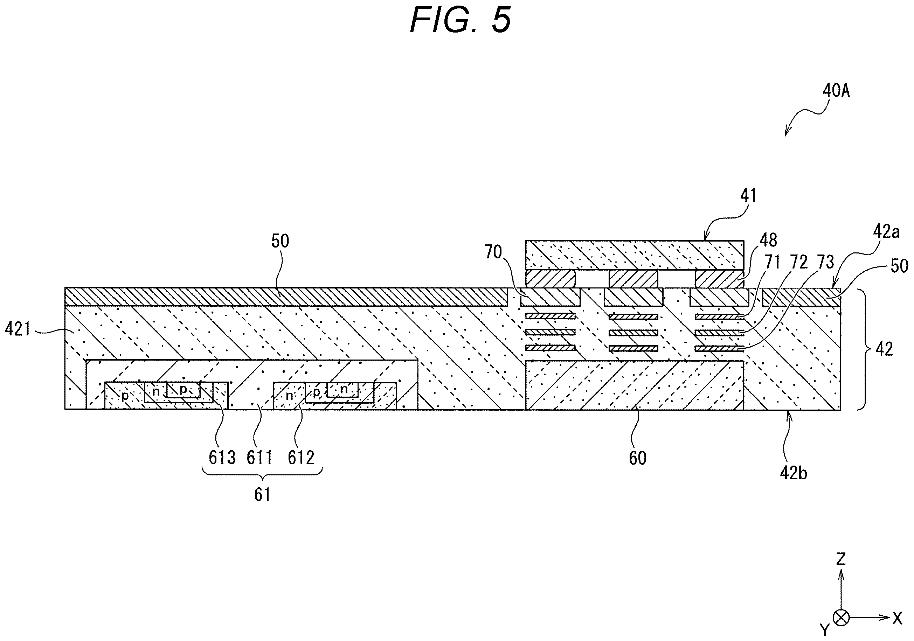

On the upper surface 42a of the LDD substrate 42, the coverage by the light-shielding film 50 is preferably high. For example, on the upper surface 42a of the LDD substrate 42, the coverage per unit area by the light-shielding film 50 is preferably 50% or more, more preferably 65% or more, and still more preferably 80% or more, except for a region where the LD chip 41 is mounted. The light-shielding film 50 may be provided to cover the entire upper surface 42a of the LDD substrate 42 except for the region where the LD chip 41 is mounted (i.e., so as to make the coverage 1000.). An example in which the coverage per unit area is 100% except for the region where the LD chip 41 is mounted is illustrated in Fig. 5 below.

Fig. 5 is a cross-sectional view illustrating a configuration example of a VCSEL mounted body 40A according to Modification 1 of the first embodiment of the present disclosure. As illustrated in Fig. 5, in the VCSEL mounted body 40A according to Modification 1, the light-shielding film 50 is provided to cover the entire upper surface 42a of the LDD substrate 42 except for the region where the LD chip 41 is mounted. With such a configuration, the light-shielding film 50 can prevent the incidence of infrared light not only on the bias circuit 61 but also on the driver circuit 60, the CLK circuit 62, and the temperature information generation unit 63. As a result, the light-shielding film 50 can further reduce a change in the characteristics of each element provided on the LDD substrate 42 due to the photovoltaic effect and can further reduce the possibility that the drive circuit 12 malfunctions.

### (Modification 2)

In the first embodiment of the present disclosure, in addition to the light-shielding film 50, some of the wiring layers 71 to 73 may function as a light-shielding unit. The wiring layer functioning as the light-shielding unit is made of a metal having a light-shielding property against infrared light, such as aluminum (Al) or copper (Cu).

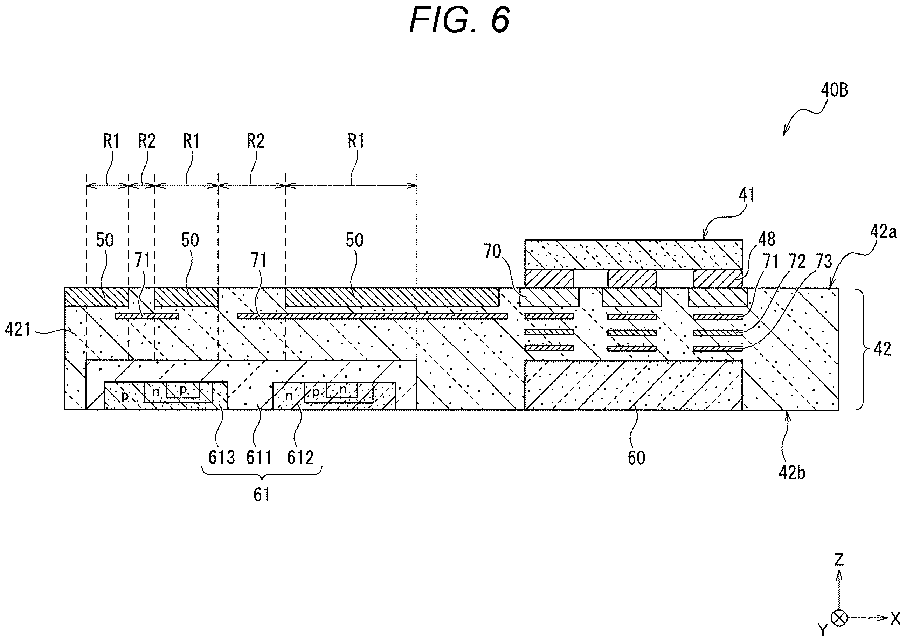

Fig. 6 is a cross-sectional view illustrating a configuration example of a VCSEL mounted body 40B according to Modification 2 of the first embodiment of the present disclosure. As illustrated in Fig. 6, in the VCSEL mounted body 40B according to Modification 2, for example, a part of the wiring layer 71 extends to above the bias circuit 61. The bias circuit 61 includes a first region R1 overlapping with the light-shielding film 50 in the thickness direction (e.g., in the Z-axis direction) of the LDD substrate 42 and a second region R2 not overlapping with the light-shielding film 50 in the Z-axis direction. The wiring layer 71 covers at least a part of the second region R2. The wiring layer 71 is made of a metal having a light-shielding property against infrared light, such as aluminum (Al) or copper (Cu).

In the VCSEL mounted body 40B according to Modification 2, the positions of the light-shielding film 50 and the wiring layer 71 in the horizontal direction are shifted from each other. The light-shielding film 50 and the wiring layer 71 in such a positional relationship prevent the incidence of infrared light on the bias circuit 61. Therefore, similarly to the first embodiment described above, it is possible to reduce a change in characteristics of the element due to the photovoltaic effect, and it is possible to reduce the possibility that the drive circuit 12 malfunctions.

### (Modification 3)

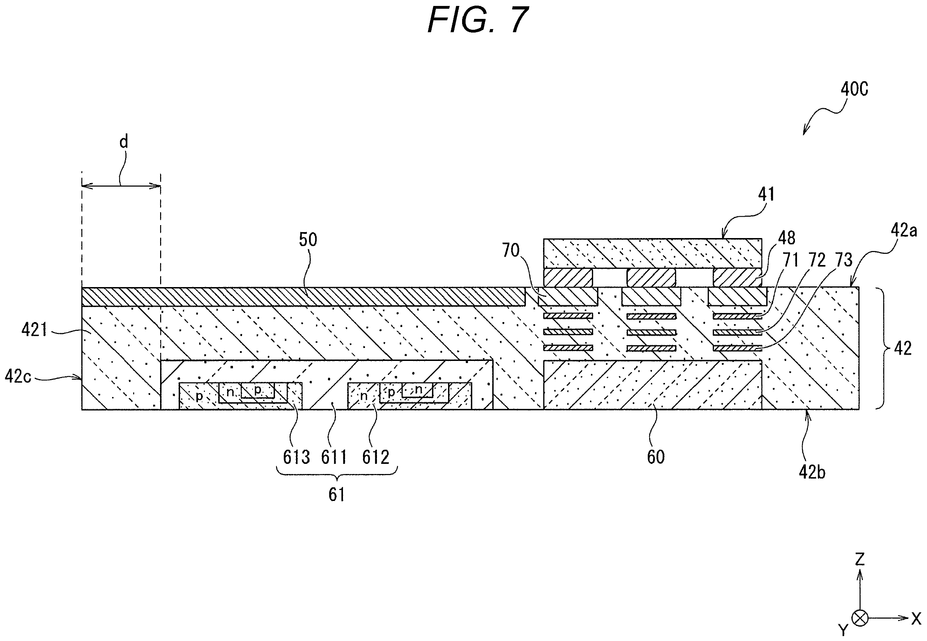

In the first embodiment of the present disclosure, the bias circuit 61 is preferably disposed at a position away from a side surface 42c of the outer periphery of the LDD substrate 42. Fig. 7 is a cross-sectional view illustrating a configuration example of a VCSEL mounted body 40C according to Modification 3 of the first embodiment of the present disclosure. As illustrated in Fig. 7, in the VCSEL mounted body 40C according to Modification 3, the bias circuit 61 is disposed at a position sufficiently away from the side surface 42c of the outer periphery of the LDD substrate 42. For example, a distance d from the side surface 42c of the outer periphery of the LDD substrate to the bias circuit 61 is 500 µm or more.

There is a possibility that a part of the light reflected by the surface of the correction lens 46 is re-reflected by the inner side surface of the correction lens holder 45 (cf. Fig. 2) or the like and incident on the side surface 42c of the outer periphery of the LDD substrate 42. However, in the VCSEL mounted body 40C, the bias circuit 61 is disposed at a position sufficiently away from the side surface 42c of the outer periphery of the LDD substrate 42, so that it is possible to reduce the possibility that the light incident from the side surface 42c reaches the bias circuit 61. It is thereby possible to further reduce a change in the characteristics of the bias circuit 61 due to the photovoltaic effect.

### (Modifications 4A, 4B)

In the first embodiment of the present disclosure, a through layer made of a light-shielding material may be provided between the side surface 42c of the outer periphery of the LDD substrate 42 and the drive circuit 12 (cf. Fig. 1).

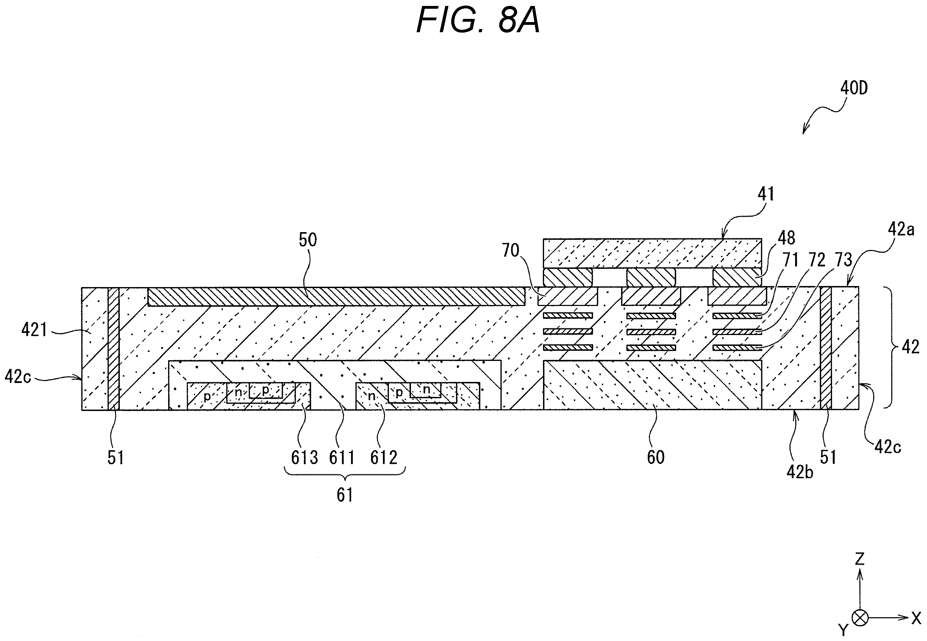

Fig. 8A is a cross-sectional view illustrating a configuration example of a VCSEL mounted body 40D according to Modification 4A of the first embodiment of the present disclosure. As illustrated in Fig. 8A, in the VCSEL mounted body 40D according to Modification 4A, the LDD substrate 42 has a through layer 51 penetrating the LDD substrate 42 in the thickness direction (e.g., in the Z-axis direction) of the LDD substrate 42. The through layer 51 is made of a metal having a light-shielding property against infrared light, such as aluminum (Al) or copper (Cu). The through layer 51 is provided between the side surface 42c of the outer periphery of the LDD substrate 42 and the bias circuit 61 and is provided in a ring shape along the side surface 42c of the outer periphery, for example.

As described above, there is a possibility that a part of the light reflected by the surface of the correction lens 46 is re-reflected by the inner side surface of the correction lens holder 45 (cf. Fig. 2) or the like and incident on the side surface 42c of the outer periphery of the LDD substrate 42. However, in the VCSEL mounted body 40D, the bias circuit 61 is shielded by the through layer 51 provided along the side surface 42c of the outer periphery, so that it is possible to reduce the possibility that the light incident from the side surface 42c reaches the bias circuit 61 It is thereby possible to further reduce a change in the characteristics of the bias circuit 61 due to the photovoltaic effect.

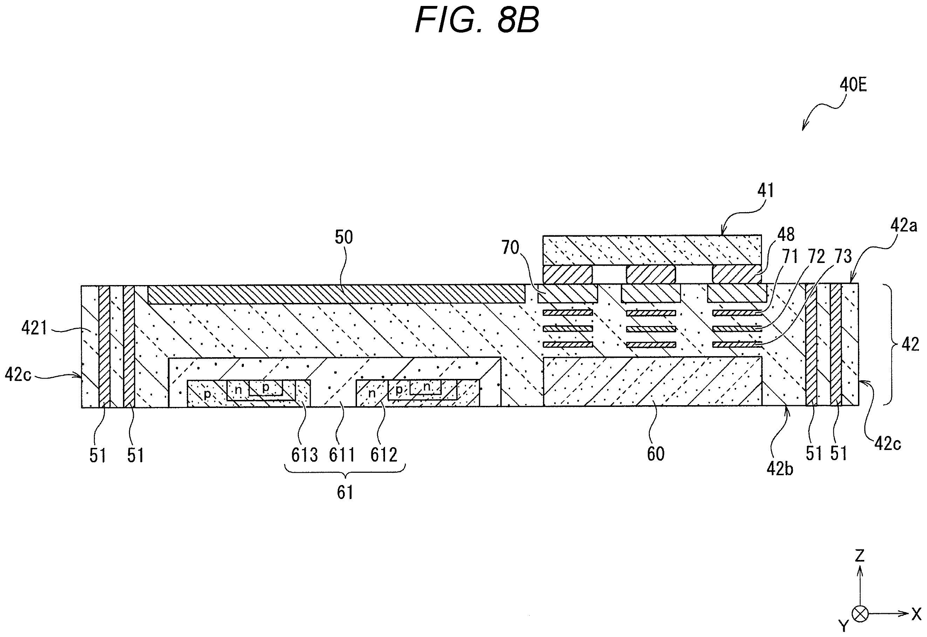

Fig. 8B is a cross-sectional view illustrating a configuration example of a VCSEL mounted body 40E according to Modification 4B of the first embodiment of the present disclosure. As illustrated in Fig. 8B, a plurality of through layers 51 may be provided instead of one through layer. For example, two through layers 51, or three or more through layers 51, may be provided along the side surface 42c of the outer periphery. With such a configuration, it is possible to further reduce the possibility that the light incident from the side surface 42c reaches the bias circuit 61.

### (Modifications 5A, 5B)

In the first embodiment described above, it has been described that the light-shielding film 50 is made of a metal such as aluminum (Al) or copper (Cu). However, the first embodiment of the present disclosure is not limited thereto. The light-shielding film 50 may be made of, for example, resin.

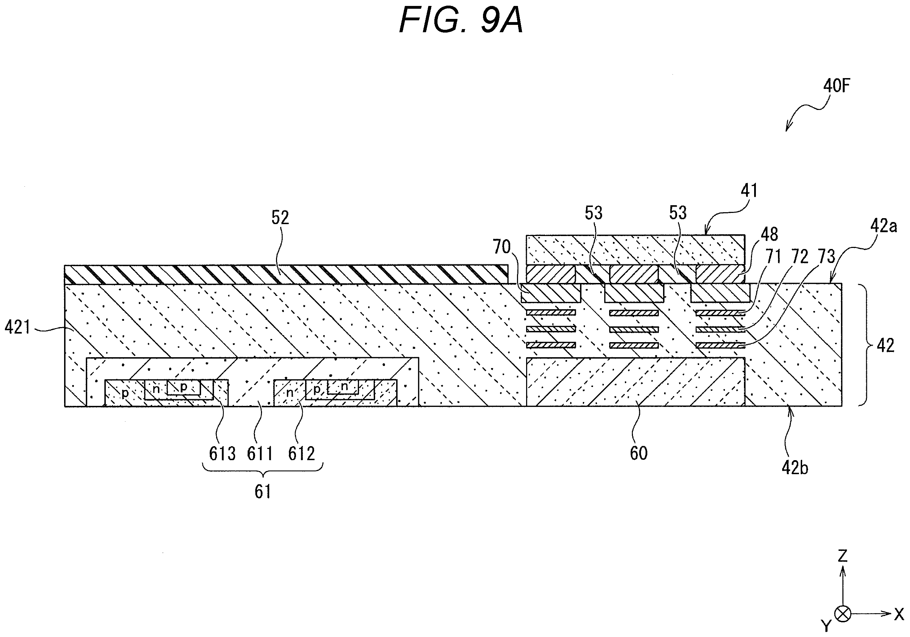

Fig. 9A is a cross-sectional view illustrating a configuration example of a VCSEL mounted body 40F according to Modification 5A of the first embodiment of the present disclosure. As illustrated in Fig. 9A, the VCSEL mounted body 40F according to Modification 5A includes a light-shielding film 52 instead of the light-shielding film 50 made of metal. The light-shielding film 52 is made of a resin having a light-shielding property against infrared light. Even with such a configuration, the light-shielding film 52 can prevent the incidence of infrared light on the bias circuit 61 and can reduce a change in characteristics of the element due to the photovoltaic effect. Hence the light-shielding film 52 can reduce the possibility that the drive circuit 12 malfunctions.

Furthermore, in the first embodiment of the present disclosure, as illustrated in Fig. 9A, a gap between the LDD substrate 42 and the LD chip 41 may be filled with an insulating resin 53. The resin 53 may be referred to as an underfill material. The resin 53 can enhance reliability of the connection between the LDD substrate 42 and the LD chip 41. As the resin 53, for example, an epoxy resin can be used.

In the VCSEL mounted body 40F according to Modification 5A, the resin 53 and the light-shielding film 52 described above may have the same composition. In addition, the resin 53 and the light-shielding film 52 described above may be formed simultaneously in the same step. Accordingly, there is a possibility that the number of steps can be reduced at the time of manufacturing the VCSEL mounted body 40F, and there is a possibility that the manufacturing cost can be reduced.

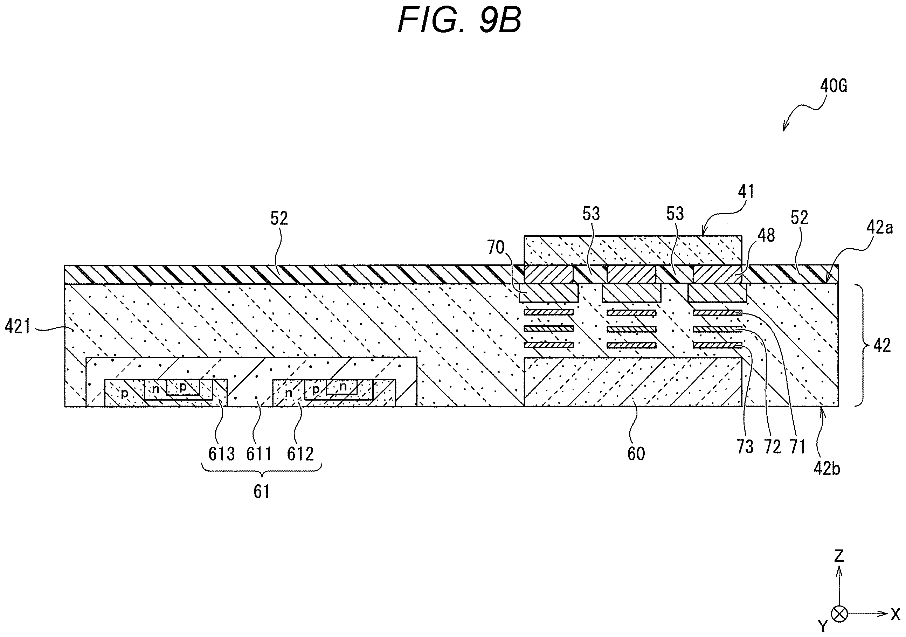

Fig. 9B is a cross-sectional view illustrating a configuration example of a VCSEL mounted body 40G according to Modification 5B of the first embodiment of the present disclosure. As illustrated in Fig. 9B, the light-shielding film 52 may be provided on the entire upper surface 42a of the LDD substrate 42 except for the region where the LD chip 41 is mounted. With such a configuration, the light-shielding film 52 can prevent the incidence of infrared light not only on the bias circuit 61 but also on the CLK circuit 62 and the temperature information generation unit 63, so that it is possible to further reduce the possibility that the drive circuit 12 malfunctions.

### <Second Embodiment>

In an embodiment of the present disclosure, the LDD substrate 42 may have a wire bonding pad electrode (WB pad electrode) to which a wire such as a gold wire is connected. An opening that exposes the surface of the WB pad electrode is provided on the WB pad electrode, and a wire is connected to the surface of the WB pad electrode through the opening. In an embodiment of the present disclosure, the light-shielding film 50 may cover not only the upper portion of the drive circuit 12 but also the periphery of the wire bonding pad electrode.

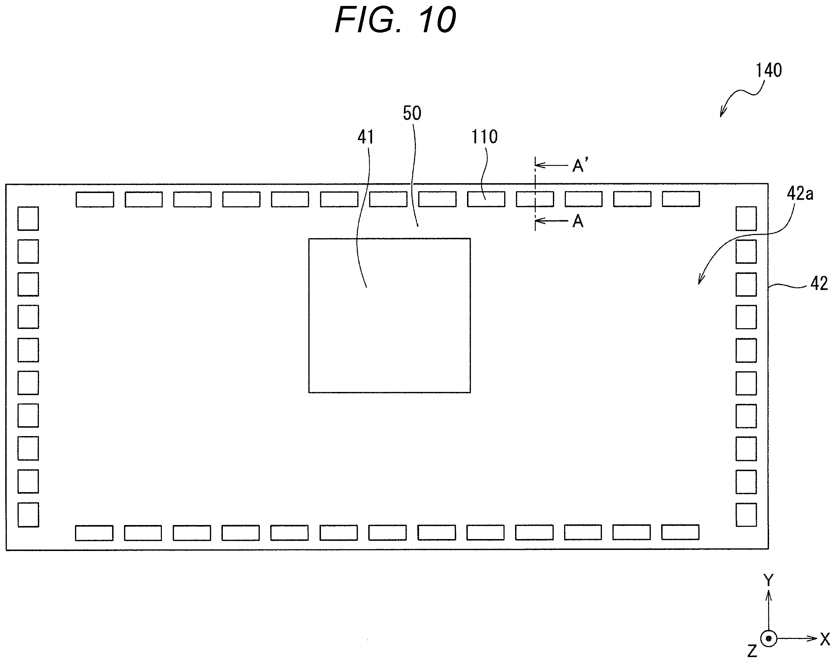

Fig. 10 is a plan view illustrating a structural example of a VCSEL mounted body 140 according to a second embodiment of the present disclosure. As illustrated in Fig. 10, a VCSEL mounted body 140 according to the second embodiment is a structural body in which a laser diode (LD) chip 41 including a VCSEL is flip chip-mounted on an LDD substrate 42, similarly to the VCSEL mounted body 40 illustrated in Fig. 4. For example, in the distance measuring device 100 illustrated in Fig. 1, the VCSEL mounted body 140 is disposed on the mounting substrate 43 via the heat dissipation substrate 44 instead of the VCSEL mounted body 40.

As illustrated in Fig. 10, the LDD substrate 42 has a plurality of WB pad electrodes 110 (an example of a "wire bonding pad electrode" of the present disclosure) provided on the upper surface 42a side of the LDD substrate 42, and a protective film 120 provided on the upper surface 42a side of the LDD substrate 42. The WB pad electrode 110 is a pad electrode for connecting a wire such as a gold wire (not illustrated). The plurality of WB pad electrodes 110 is provided on the outer peripheral portion of the LDD substrate 42 in a plan view from the normal direction (e.g., Z-axis direction) of the upper surface 42a of the LDD substrate 42 and is arranged at regular intervals so as to draw a rectangular frame along the outer periphery of the LDD substrate 42.

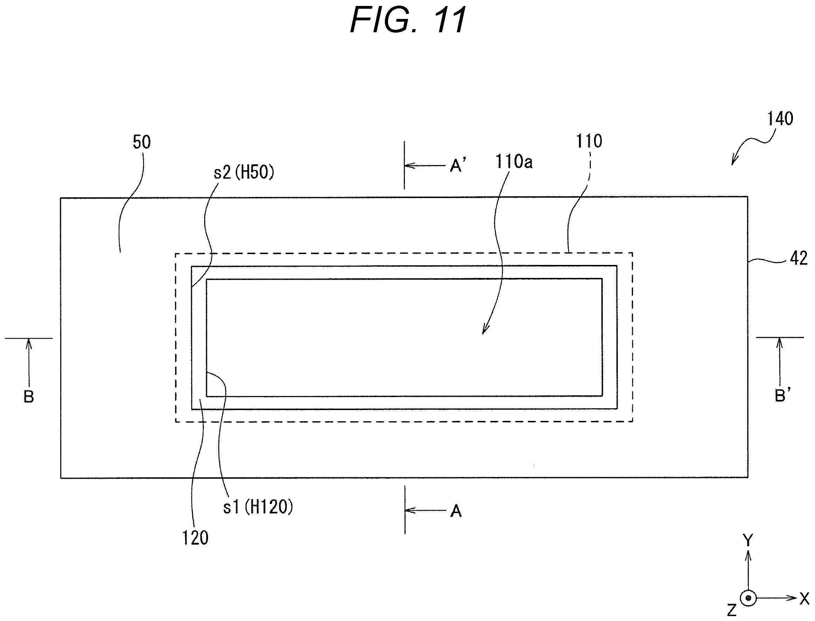

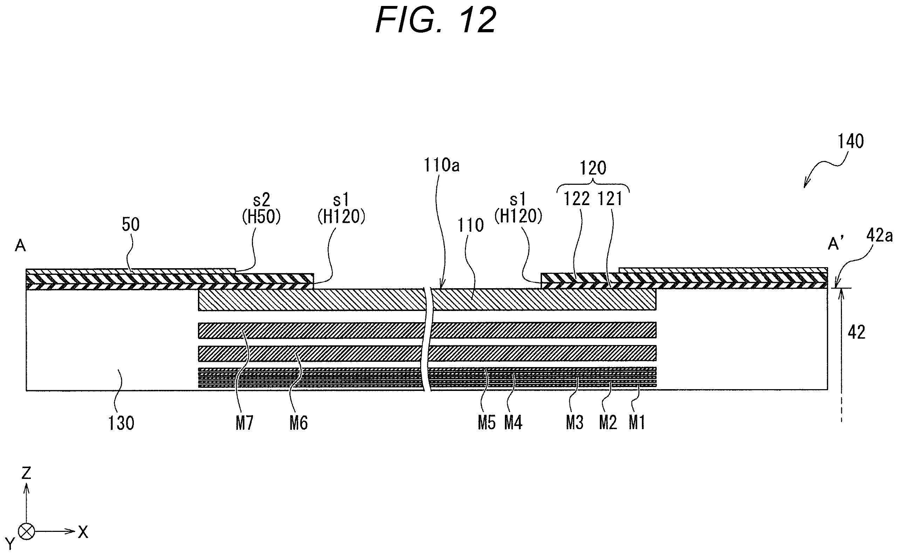

Fig. 11 is an enlarged plan view illustrating the WB pad electrode 110 and its peripheral portion illustrated in Fig. 10. Fig. 12 is a cross-sectional view illustrating a configuration example of the VCSEL mounted body 40 according to the second embodiment of the present disclosure. Fig. 12 illustrates the cross-section of the plan view illustrated in Figs. 10 and 11 taken along line A-A'. Note that the cross-section of the plan view illustrated in Fig. 11 taken along line B-B' has a similar configuration to the cross-section of the plan view illustrated in Fig. 11 taken along line A-A'.

As illustrated in Figs. 11 and 12, the protective film 120 includes an opening H120 that exposes the surface of the WB pad electrode 110. As illustrated in Fig. 11, in a plan view from the Z-axis direction, the opening H120 is located inside the WB pad electrode 110, and the bottom surface of the opening H120 is the surface of the WB pad electrode 110.

As illustrated in Figs. 11 and 12, the light-shielding film 50 is provided on the protective film 120. The light-shielding film 50 is also provided with an opening H50. The opening H50 provided in the light-shielding film 50 is located above the WB pad electrode 110 and communicates with the opening H120 provided in the protective film 120.

The WB pad electrode 110 is made of, for example, aluminum (Al) or an Al alloy containing Al. The protective film 120 includes, for example, a silicon oxide film (SiO₂ film) 121 and a silicon nitride film (SiN) 122 provided on the SiO₂ film 121. The light-shielding film 50 includes, for example, titanium (Ti) and gold (Au) provided on Ti.

As illustrated in Fig. 12, a plurality of (e.g., seven) wires M1 to M7 stacked in the Z-axis direction via the interlayer insulating film 130 is provided below the WB pad electrode 110. For example, the wires M6, M7 are power supply lines. The wires M1 to M5 are signal lines. At least some of the wires M1 to M7 located below the WB pad electrode 110 may be dummy wires that are not electrically connected to an element such as a transistor.

In the VCSEL mounted body 140 according to the second embodiment, not only the upper portion the drive circuit 12 but also the periphery of the WB pad electrode 110 is covered with the light-shielding film 50. Even in a case where a part of the light (e.g., infrared light) emitted from the light-emitting unit is reflected by the surface of the lens and directed to the periphery of the WB pad electrode 110, this light (ambient light) is shielded by the light-shielding film 50. Therefore, the light-shielding film 50 can reduce the entry of light into the LDD substrate 42 from the periphery of the WB pad electrode 110 and can further reduce the possibility that the drive circuit 12 malfunctions.

In the second embodiment, a portion of the light-shielding film 50 disposed around the WB pad electrode 110 is an example of a "peripheral light-shielding unit" of the present disclosure.

### <Third Embodiment>

As described in the second embodiment, the opening H120 for exposing the surface of the WB pad electrode 110 is provided on the WB pad electrode 110, and a wire is connected to the surface of the WB pad electrode 110 through the opening H120. With the side surface of the opening H120 being exposed from the light-shielding film 50, there is a possibility that the side surface becomes an entrance of light into the LDD substrate 42. In order to reduce this possibility, in the embodiment of the present disclosure, the side surface of the opening H120 may be covered with a peripheral light-shielding unit. As such an aspect, Configuration Examples 1 to 3 of the third embodiment will be described.

### (Configuration Example 1)

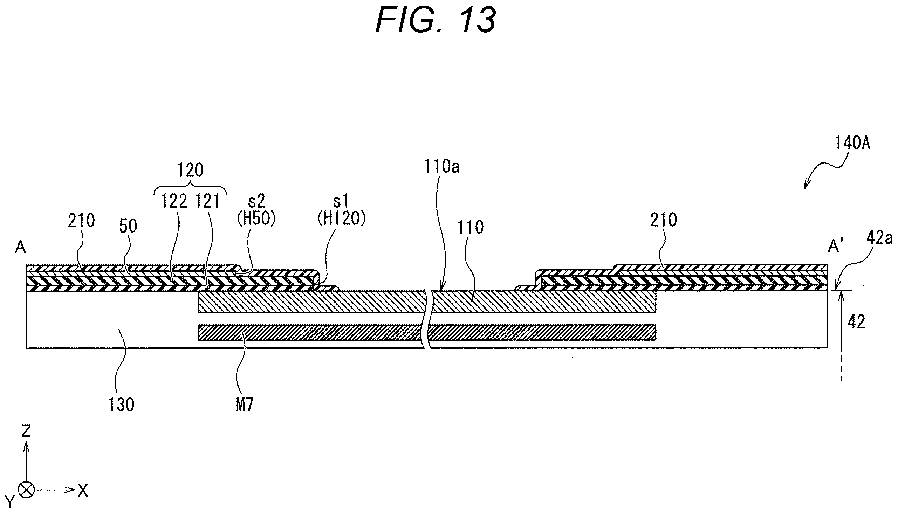

Fig. 13 is a cross-sectional view illustrating a configuration example (Configuration Example 1) of a VCSEL mounted body 140A according to a third embodiment of the present disclosure. As illustrated in Fig. 13, in the VCSEL mounted body 140A, a light-shielding resin 210 (an example of the "peripheral light-shielding unit" of the present disclosure) is applied around the opening H120.

The light-shielding resin 210 is an insulating resin. In addition, the light-shielding resin 210 has a light-shielding property against light emitted from the light-emitting unit 11. For example, the light-shielding resin 210 is a dark or black insulating resin and has a shielding property against infrared light emitted from the light-emitting unit 11. The light-shielding resin 210 may be a resin called a black matrix.

As illustrated in Fig. 13, the light-shielding resin 210 continuously covers the light-shielding film 50, a side surface s2 of the opening H50 provided in the light-shielding film 50, the top of the protective film 120 exposed from below the light-shielding film 50, a side surface s1 of the opening H120 provided in the protective film 120, and the top of the WB pad electrode 110 located in the vicinity of the side surface s1 of the opening H120.

An interface end between the WB pad electrode 110 and the protective film 120 and the side surface s1 of the opening H120 can be cited as an entrance of light (ambient light) from the opening H120 to the LDD substrate 42. In addition, an interface end between the protective film 120 and the light-shielding film 50 can be cited as an entrance of the ambient light from the opening H50 into the LDD substrate 42. The light-shielding resin 210 covers and closes these entrances.

In the VCSEL mounted body 140A according to Configuration Example 1 of the third embodiment, the light-shielding resin 210 covers the side surfaces s1, s2 of the openings H120, H50. Thus, the light-shielding resin 210 can prevent ambient light from entering the LDD substrate 42 through the openings H120, H50 and can shield at least some (e.g., the bias circuit 61) of the drive circuit 12 from the ambient light. Therefore, the light-shielding resin 210 can further reduce the possibility that the drive circuit 12 malfunctions.

The light-shielding resin 210 preferably covers the entire side surface s1 of the opening H120. Hence the light-shielding resin 210 easily shields the entrance of the ambient light present on the side surface s1 of the opening H120 and the like.

Note that Configuration Example 1 of the third embodiment is not limited to the above. The light-shielding resin 210 may be disposed to cover not the entire side surface s1 of the opening H120 but a part of the side surface s1. For example, the light-shielding resin 210 may be applied so as to cover the side surface on the side closer to the drive circuit 12 and so as not to cover the side surface on the side farther from the drive circuit 12 among the side surfaces s1 of the opening H120. In this case, there is a possibility that the entry of the ambient light into the drive circuit 12 can be reduced as compared with a case where the side surface on the side close to the drive circuit 12 is not covered with the light-shielding resin 210.

### (Configuration Example 2)

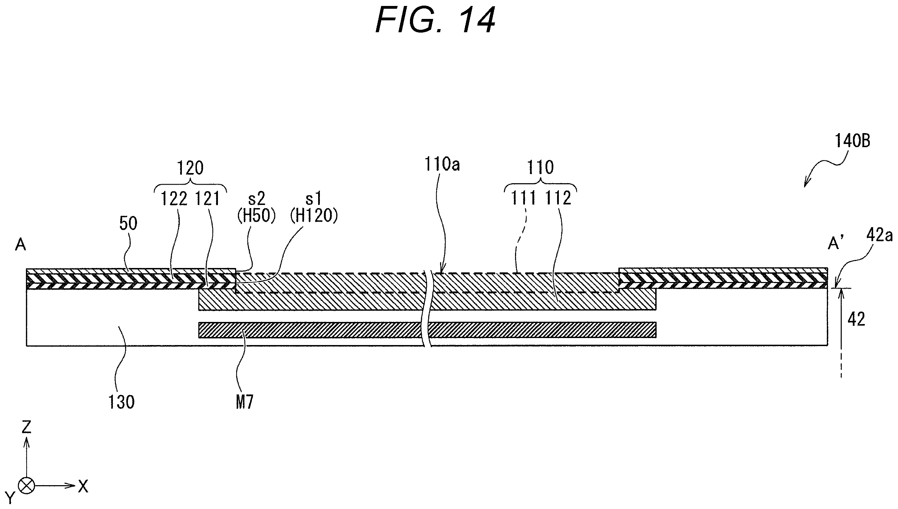

Fig. 14 is a cross-sectional view illustrating a configuration example (Configuration Example 2) of a VCSEL mounted body 140B according to the third embodiment of the present disclosure. In the VCSEL mounted body 140B illustrated in Fig. 14, the WB pad electrode 110 has a thick film portion 111 (an example of the "peripheral light-shielding unit" of the present disclosure) having an increased thickness inside the opening H120. For example, the WB pad electrode 110 includes a thick film portion 111 located inside the opening H120 and the other portion 112 located outside the opening H120. The thick film portion 111 and the other portion 112 are made of the same material and are integrally formed. In the VCSEL mounted body 140B, the thick film portion 111 of the WB pad electrode 110 covers and closes the side surface s1 of the opening H120 serving as the entrance of the ambient light and the interface end between the WB pad electrode 110 and the protective film 120.

As a result, the thick film portion 111 of the WB pad electrode 110 can prevent ambient light from entering the LDD substrate 42 through the opening H120 and can shield at least a part (e.g., the bias circuit 61) of the drive circuit 12 from the ambient light. Therefore, the thick film portion 111 can further reduce the possibility that the drive circuit 12 malfunctions.

The thick film portion 111 preferably covers the entire side surface s1 of the opening H120. Hence the thick film portion 111 easily shields the entrance of the ambient light existing on the side surface s1 of the opening H120 and the like.

Note that Configuration Example 2 of the third embodiment is not limited to the above. The thick film portion 111 may be disposed to cover not the entire side surface s1 of the opening H120 but a part of the side surface s1. For example, the thick film portion 111 may be formed so as to cover the side surface on the side closer to the drive circuit 12 and so as not to cover the side surface on the side farther from the drive circuit 12 among the side surfaces s1 of the opening H120. In this case, there is a possibility that the entry of the ambient light into the drive circuit 12 can be reduced as compared with a case where the side surface on the side close to the drive circuit 12 is not covered with the thick film portion 111.

### (Configuration Example 3)

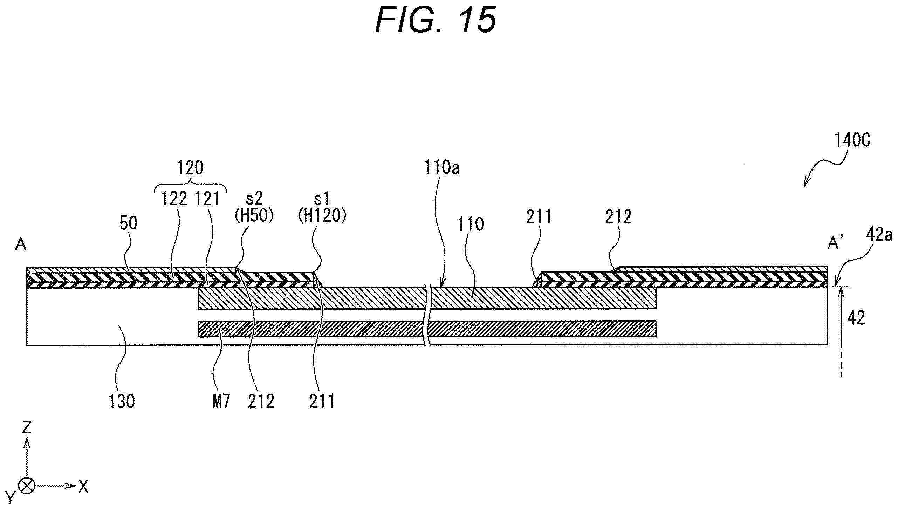

Fig. 15 is a cross-sectional view illustrating a configuration example (Configuration Example 3) of a VCSEL mounted body 140C according to the third embodiment of the present disclosure. A VCSEL mounted body 140C illustrated in Fig. 15 includes a sidewall 211 disposed on the side surface s1 of the opening H120 provided in the protective film 120, and a sidewall 212 disposed on the side surface s2 of the opening H50 provided in the light-shielding film 50. Each of the sidewalls 211, 212 is an example of the "peripheral light-shielding unit" of the present disclosure.

The sidewalls 211, 212 are made of an insulating resin. In addition, the sidewalls 211, 212 have a light-shielding property against light emitted from the light-emitting unit 11. For example, the sidewalls 211, 212 are made of a dark or black resin and have a shielding property against infrared light emitted from the light-emitting unit 11. The resin constituting the sidewalls 211, 212 may be made of a resin called a black matrix.

The sidewalls 211, 212 are formed, for example, by applying an insulating dark or black resin to the upper surface 42a of the LDD substrate 42 in which the openings H120, H50 are formed, and etching back the applied resin.

In the VCSEL mounted body 140C, the sidewall 211 covers and closes the side surface s1 of the opening H120 serving as an entrance for the ambient light, and the interface end between the WB pad electrode 110 and the protective film 120. Similarly, in the VCSEL mounted body 140C, the sidewall 212 covers and closes the interface end between the protective film 120 and the light-shielding film 50 serving as the entrance of the ambient light. As a result, the sidewalls 211, 212 can prevent the entry of ambient light from the openings H120, H50 into the LDD substrate 42 and can shield at least a part (e.g., the bias circuit 61) of the drive circuit 12 from the ambient light. Therefore, the sidewalls 211, 212 can further reduce the possibility that the drive circuit 12 malfunctions.

The sidewall 211 preferably covers the entire side surface s1 of the opening H120. Hence the sidewall 211 easily shields the entrance of the ambient light existing on the side surface s1 of the opening H120 and the like. Similarly, the sidewall 212 preferably covers the entire side surface s2 of the opening H50. Hence the sidewall 211 easily shields the entrance of the ambient light existing in the vicinity of the side surface s2 of the opening H50.

Note that Configuration Example 3 of the third embodiment is not limited to the above. For example, only one of the sidewalls 211, 212 may be provided.

Further, the sidewall 211 may be disposed to cover not the entire side surface s1 of the opening H120 but a part of the side surface s1. For example, the sidewall 211 may be formed so as to cover the side surface on the side closer to the drive circuit 12 and so as not to cover the side surface on the side farther from the drive circuit 12 among the side surfaces s1 of the opening H120. In this case, there is a possibility that the entry of the ambient light into the drive circuit 12 can be reduced as compared with a case where the side surface on the side close to the drive circuit 12 is not covered with the sidewall 211.

Similarly, the sidewall 212 may be disposed to cover not the entire side surface s2 of the opening H50 but a part of the side surface s2. In this case, the sidewall 212 may be formed so as to cover the side surface on the side closer to the drive circuit 12 and so as not to cover the side surface on the side farther from the drive circuit 12 among the side surfaces s2 of the opening H50. In this case, there is a possibility that the entry of the ambient light into the drive circuit 12 can be reduced as compared with a case where the side surface on the side close to the drive circuit 12 is not covered with the sidewall 212.

### <Fourth Embodiment>

In the embodiment of the present disclosure, the peripheral light-shielding unit may be disposed to shield the propagation path of the ambient light having entered from the opening H120 or the like. As such an aspect, Configuration Examples 1 to 4 of the fourth embodiment will be described.

### (Configuration Example 1)

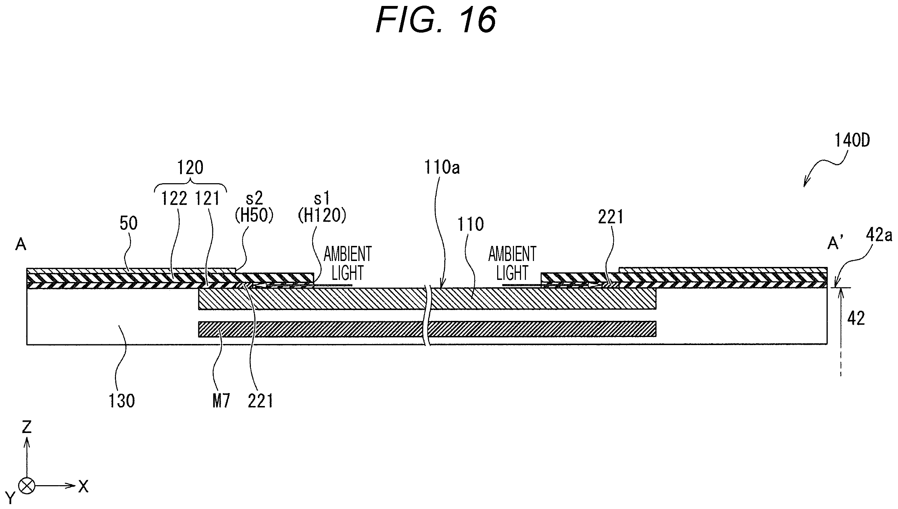

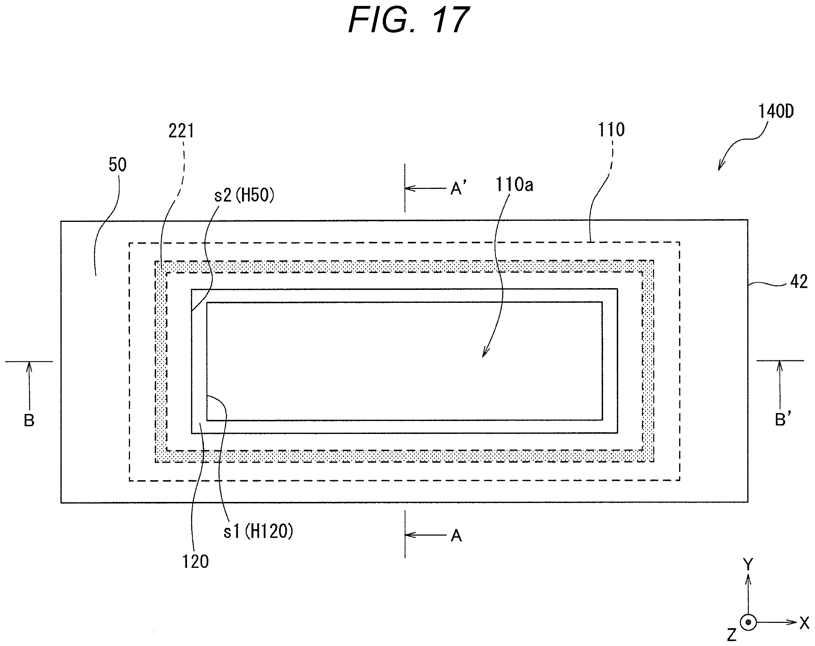

Fig. 16 is a cross-sectional view illustrating a configuration example (Configuration Example 1) of a VCSEL mounted body 140D according to a fourth embodiment of the present disclosure. Fig. 17 is an enlarged plan view illustrating the WB pad electrode 110 and its peripheral portion illustrated in Fig. 16. The cross-section illustrated in Fig. 16 is a cross-section obtained by cutting the plan view illustrated in Fig. 17 along line A-A'. Note that the cross-section of the plan view illustrated in Fig. 17 taken along line B-B' has a similar configuration to the cross-section of the plan view illustrated in Fig. 17 taken along line A-A'.

As illustrated in Fig. 16, at least a part of the ambient light having entered from the opening H120 propagates through the interface between the WB pad electrode 110 and the protective film 120 and through the SiO₂ film 121 constituting the protective film 120. In the VCSEL mounted body 140D, an opaque member 221 (an example of the "peripheral light-shielding unit" of the present disclosure) is disposed between the WB pad electrode 110 and the protective film 120 and blocks the propagation path of the ambient light. The opaque member 221 absorbs and attenuates the ambient light propagating along the propagation path.

The opaque member 221 is made of, for example, titanium nitride (TiN). TiN is formed by forming a film by a semiconductor manufacturing process, such as chemical vapor deposition (CVD) or sputtering, and using a photolithography technique to perform patterning.

The opaque member 221 is preferably in contact with the SiN film 122. As a result, the opaque member 221 can divide the SiO₂ film 121 on the WB pad electrode 110 and can absorb and attenuate ambient light propagating in the SiO₂ film 121. For example, after the opaque member 221 is formed on the WB pad electrode 110, the SiO₂ film 121 is formed on the LDD substrate 42, the surface of the SiO₂ film 121 is subjected to chemical mechanical polishing (CMP) treatment to expose the surface of the opaque member 221, and then the SiN film 122 is formed, whereby the opaque member 221 can be brought into contact with the SiN film 122.

In the VCSEL mounted body 140D according to the fourth embodiment, the opaque member 221 shields the propagation path of the ambient light, so that at least a part (e.g., the bias circuit 61) of the drive circuit 12 can be shielded from the ambient light. Therefore, the opaque member 221 can further reduce the possibility that the drive circuit 12 malfunctions.

Further, as illustrated in Fig. 17, the opaque member 221 is preferably provided continuously so as to surround the opening H120 from the outside in a plan view from the Z-axis direction. Hence the opaque member 221 can easily shield the propagation path of the ambient light.

Note that Configuration Example 1 of the fourth embodiment is not limited to the above. The opaque member 221 may be intermittently provided to surround the opening H120 from the outside in cross-sectional view from the axial direction. In addition, the opaque member 221 may not necessarily surround the opening H120.

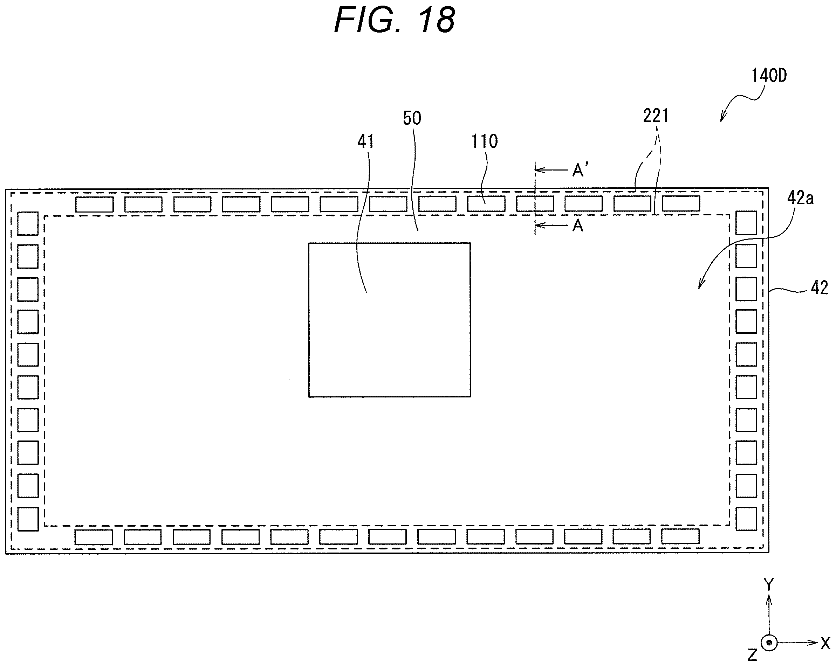

Fig. 18 is a plan view illustrating a modification of the placement of the opaque member 221. As illustrated in Fig. 18, the opaque member 221 may be disposed inside and outside a rectangular frame formed by a plurality of WB pad electrodes 110 arranged in a plan view from the Z-axis direction. Even with such a configuration, the opaque member 221 can shield the propagation path of the ambient light.

Note that Configuration Example 1 of the fourth embodiment is not limited to the above. The opaque member 221 may be disposed only on one of the inside or the outside of the rectangular frame formed by the plurality of WB pad electrodes 110 arranged in the plan view from the Z-axis direction. For example, the opaque member 221 may be disposed only inside the rectangular frame, which is the side closer to the drive circuit 12. In this case, there is a possibility that the propagation of the ambient light to the drive circuit 12 can be reduced as compared with a case where the opaque member 221 is disposed only outside the rectangular frame.

### (Configuration Example 2)

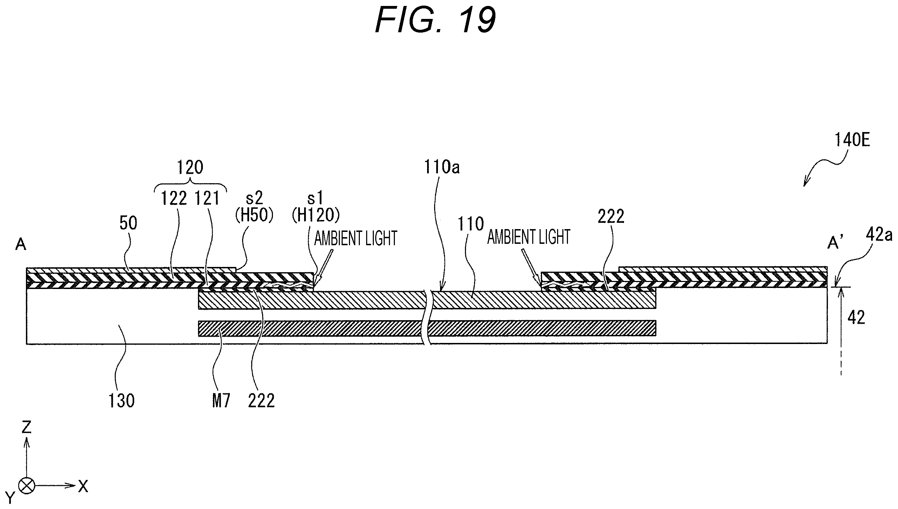

Fig. 19 is a cross-sectional view illustrating a configuration example (Configuration Example 2) of a VCSEL mounted body 140E according to the fourth embodiment of the present disclosure. In the VCSEL mounted body 140E illustrated in Fig. 19, an antireflection film 222 (an example of the "peripheral light-shielding unit" of the present disclosure) is provided between the WB pad electrodes 110 and the protective film 120 and blocks the propagation path of the ambient light. The antireflection film 222 absorbs and attenuates ambient light propagating while being reflected between the WB pad electrode 110 and the SiN film 122 and reduces the propagation of the ambient light.

The antireflection film 222 is made of, for example, a photoresist. The antireflection film 222 is formed by forming a film by a semiconductor manufacturing process, such as CVD or sputtering, and using a photolithography technique to perform patterning.

In the VCSEL mounted body 140E according to Configuration Example 2 of the fourth embodiment, the antireflection film 222 shields the propagation path of the ambient light, so that at least a part (e.g., the bias circuit 61) of the drive circuit 12 can be shielded from the ambient light. Therefore, the antireflection film 222 can further reduce the possibility that the drive circuit 12 malfunctions.

Further, the antireflection film 222 is preferably provided continuously to surround the opening H120 from the outside in a plan view from the Z-axis direction as in the opaque member 221 illustrated in Fig. 17. Hence the antireflection film 222 can easily shield the propagation path of the ambient light.

Note that Configuration Example 1 of the fourth embodiment is not limited to the above. The antireflection film 222 may be intermittently provided to surround the opening H120 from the outside in cross-sectional view from the axial direction. In addition, the antireflection film 222 may not necessarily surround the opening H120.

Furthermore, the modification illustrated in Fig. 18 may also be applied to Configuration Example 2 of the fourth embodiment. In Fig. 18, the opaque member 221 may be replaced with the antireflection film 222. The antireflection film 222 may be disposed on at least one of the inside or the outside of the rectangular frame formed by the plurality of WB pad electrodes 110 arranged in the plan view from the Z-axis direction. Even in this case, the antireflection film 222 can shield the propagation path of the ambient light.

### (Configuration Example 3)

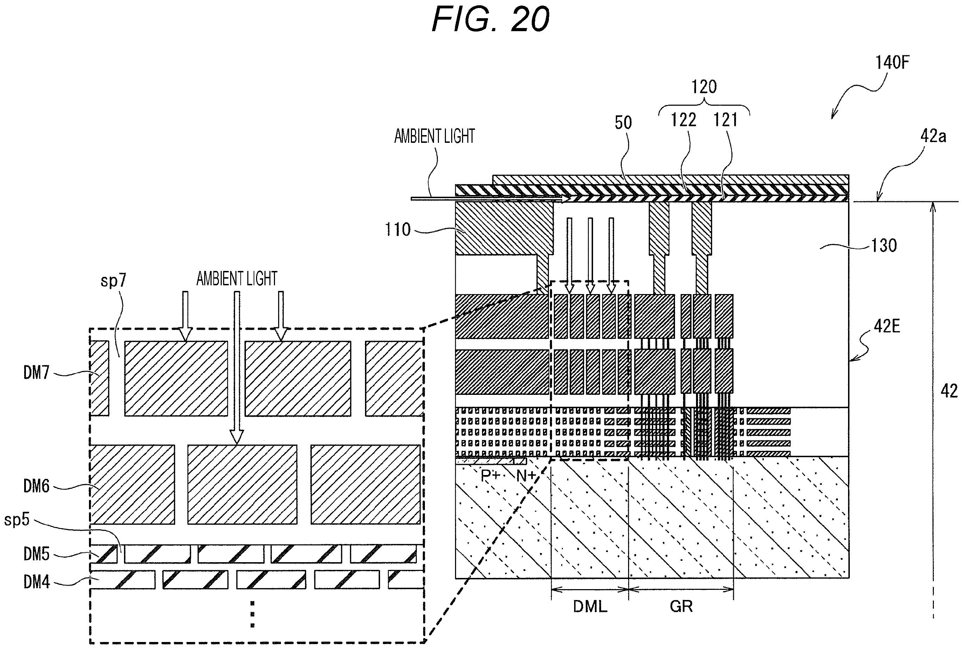

Fig. 20 is a cross-sectional view illustrating a configuration example (Configuration Example 3) of a VCSEL mounted body 140F according to the fourth embodiment of the present disclosure. The right end of the right diagram in Fig. 20 is the outer peripheral end of the LDD substrate 42. The diagram on the left side of Fig. 20 is an enlarged cross-sectional view illustrating a light-shielding dummy wiring layer DML (an example of the "peripheral light-shielding unit" of the present disclosure) provided on the LDD substrate 42.

As illustrated in Fig. 20, a guard ring GR exists between the WB pad electrode 110 and the outer peripheral end 42E of the LDD substrate 42 in order to prevent the entry of moisture, impurities, and the like. The guard ring GR is formed of a metal layer formed in the same layer as the wires M1 to M7 and the WB pad electrode 110. The metal layer constituting the guard ring GR is a dummy wire or a dummy electrode that is not electrically connected to an element such as a transistor.

In a case where the ambient light propagates through the interface between the WB pad electrode 110 and the protective film 120 or through the SiO₂ film 121 constituting the protective film 120, there is a possibility that at least a part of the ambient light further propagates into the LDD substrate 42 through the periphery of the WB pad electrode 110. In consideration of this possibility, in the VCSEL mounted body 140F, the light-shielding dummy wiring layer DML is disposed on the outer periphery of the WB pad electrode 110 and a region immediately below the WB pad electrode. For example, the dummy wiring layer DML is disposed between the WB pad electrode / the region immediately below the WB pad electrode 110 and the guard ring GR. The dummy wiring layer DML may be disposed on the entire outer periphery of the WB pad electrode 110 and the region immediately below the WB pad electrode or may be disposed on a part of the outer periphery of the WB pad electrode 110.

Further, in the light-shielding dummy wiring layer DML, a plurality of dummy wires is arranged to overlap with each other in order to shield ambient light. For example, in the left diagram of Fig. 20, a dummy wire DM7 and a dummy wire DM6 are metal wiring layers formed in the same layer as the power supply wires M7, M6 (cf. Fig. 12). Dummy wires DM5, DM4 are metal wiring layers formed in the same layer as the signal wires M5, M4 (cf. Fig. 12). The dummy wires DM7, DM6, DM5, DM4 are not electrically connected to elements such as transistors.

In the Z-axis direction, the dummy wire DM7 (an example of a "(n + m)th layer dummy wire" of the present disclosure) and the dummy wire DM6 (an example of an "nth layer dummy wire" of the present disclosure) overlap with each other such that the dummy wire DM6 overlaps with an inter-wire space sp7 of the dummy wire DM7. Thus, even in a case where the ambient light is transmitted through the inter-wire space sp7 of the dummy wire DM7, the light transmitted through the inter-wire space sp7 is reflected by the dummy wire DM6 located ahead of the inter-wire space sp7 and is attenuated.

Similarly, the dummy wire DM5 (an example of the "(n + m)th layer dummy wire" of the present disclosure) and the dummy wire DM4 (an example of the "nth layer dummy wire" of the present disclosure) overlap with each other such that the dummy wire DM4 overlaps with an inter-wire space sp5 of the dummy wire DM5. Thus, even in a case where the ambient light is transmitted through the inter-wire space sp5 of the dummy wire DM5, the light transmitted through the inter-wire space sp5 is reflected by the dummy wire DM4 located ahead of the inter-wire space sp5 and is attenuated.

As a result, the dummy wiring layer DML can shield the propagation path of the ambient light. The dummy wiring layer DML can reduce the propagation of the ambient light and can shield at least a part (e.g., the bias circuit 61) of the drive circuit 12 from the ambient light. Therefore, the dummy wiring layer DML can further reduce the possibility that the drive circuit 12 malfunctions.

Note that as described above, the dummy wires to be overlapped are preferably adjacent wires in the thickness direction of the LDD substrate 42, such as the dummy wire DM7 and the dummy wire DM6 or the dummy wire DM5 and the dummy wire DM4. That is, m in the n + m layer described above is preferably 1. Hence it is possible to reduce the diffraction of the ambient light transmitted through the inter-wire space to a small degree, and it is possible to more effectively reduce the propagation of the ambient light.

Furthermore, the modification illustrated in Fig. 18 may also be applied to Configuration Example 3 of the fourth embodiment. In Fig. 18, the opaque member 221 may be replaced with a dummy wiring layer DML. The dummy wiring layer DML may be disposed on at least one of the inside or the outside of the rectangular frame formed by the plurality of WB pad electrodes 110 arranged in the plan view from the Z-axis direction. Even in this case, the dummy wiring layer DML can shield the propagation path of the ambient light.

### (Configuration Example 4)

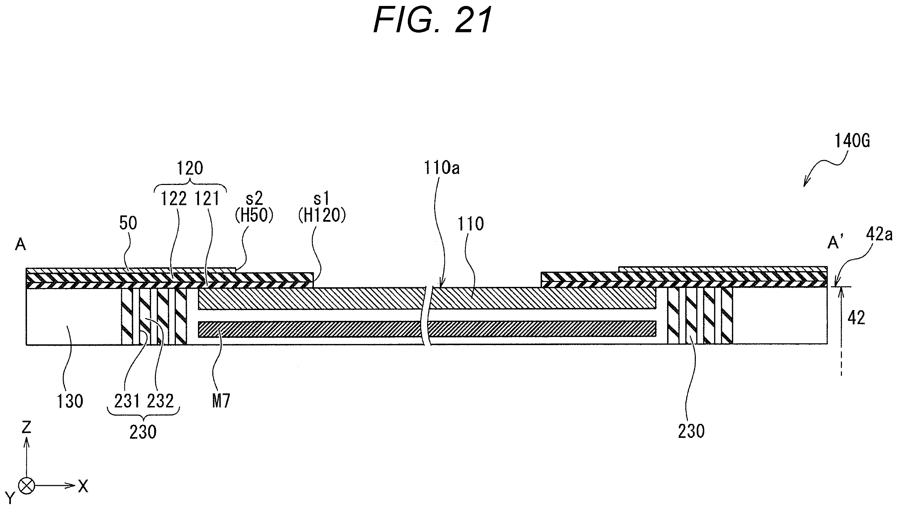

Fig. 21 is a cross-sectional view illustrating a configuration example (Configuration Example 4) of a VCSEL mounted body 140G according to the fourth embodiment of the present disclosure. As illustrated in Fig. 21, in the VCSEL mounted body 140F, a light-shielding trench isolation 230 (an example of the "peripheral light-shielding unit" of the present disclosure) is disposed on the outer periphery of the WB pad electrode 110 and a region immediately below the WB pad electrode.

The trench isolation 230 includes a trench 231 provided in the interlayer insulating film 130 and an embedded material 232 provided in the trench 231. The embedded material 232 is made of a material capable of absorbing or reflecting ambient light, such as polysilicon, metal, or a low-dielectric constant material (low-K material).

Therefore, the trench isolation 230 can shield the propagation path of the ambient light and reduce the propagation of the ambient light. The trench isolation 230 can shield at least a part (e.g., the bias circuit 61) of the drive circuit 12 from ambient light, so that it is possible to further reduce the possibility that the drive circuit 12 malfunctions.

### (Other Embodiments)

As described above, the present disclosure has been described with reference to the embodiments and the modifications, but it should not be understood that the description and the drawings constituting a part of this disclosure limit the present disclosure. Various alternative embodiments, examples, and operation techniques will be apparent to those skilled in the art from this disclosure. For example, the light emitted by the light-emitting unit 11 is not limited to infrared light. The light emitted from the light-emitting unit 11 may be visible light or ultraviolet light. Further, the light-shielding unit of the present disclosure may include both the light-shielding film 50 and the through layer 51. As described above, it is a matter of course that the present technology includes various embodiments and the like not described herein. At least one of various omissions, substitutions, or changes of the components can be made without departing from the gist of the embodiments and modifications described above. Furthermore, the effects described in the present specification are merely examples, are not limited, and may have other effects.

Note that the present disclosure can also be configured as follows:
(1) An electronic device provided with:
   a first substrate including a drive circuit;
   a second substrate including a light-emitting unit driven by the drive circuit and mounted on one surface side of the first substrate; and
   a light-shielding unit provided on the first substrate and configured to shield at least a part of the drive circuit from light emitted by the light-emitting unit.
(2) The electronic device according to (1) above, in which
   the drive circuit includes a bias circuit that applies a current to the light-emitting unit, and
   the light-shielding unit shields the bias circuit from the light.
(3) The electronic device according to (1) or (2) above, in which
   the light-shielding unit includes a light-shielding film made of a material having a light-shielding property against the light and provided on one surface of the first substrate, and
   the light-shielding film covers at least a part of the drive circuit.
(4) The electronic device according to (3) above, in which the light-shielding film is provided to cover a whole of the one surface of the first substrate except for a region where the second substrate is mounted.
(5) The electronic device according to (3) above, in which
   the first substrate includes a wiring layer provided in a layer different from the light-shielding film in a thickness direction of the first substrate and made of a material having a light-shielding property against the light,
   the drive circuit includes
   a first region overlapping with the light-shielding film in the thickness direction of the first substrate, and
   a second region not overlapping with the light-shielding film in the thickness direction of the first substrate, and
   the wiring layer covers at least a part of the second region.
(6) The electronic device according to any one of (1) to (5) above, in which a distance from a side surface of an outer periphery of the first substrate to the drive circuit is 500 µm or more.
(7) The electronic device according to any one of (1) to (6) above, in which the light-shielding unit further includes a through layer that is made of a material having a light-shielding property against the light and penetrates the first substrate in a thickness direction of the first substrate.
(8) The electronic device according to (7) above, in which the through layer is provided in a ring shape along an outer periphery of the first substrate.
(9) The electronic device according to any one of (1) to (8) above, in which the light-emitting unit includes a vertical-cavity surface-emitting laser (VCSEL).
(10) The electronic device according to any one of (1) to (9) above, in which the light includes infrared light.
(11) The electronic device according to any one of (1) to (10) above, further including a lens that is disposed at a position facing the first substrate across the second substrate and on which the light is incident.
(12) The electronic device according to any one of (1) to (11) above, in which
   the first substrate includes
   a wire bonding pad electrode provided on one surface side of the first substrate, and
   a protective film provided on one surface side of the first substrate and provided with an opening that exposes a surface of the wire bonding pad electrode, and
   the light-shielding unit includes a peripheral light-shielding unit having a light-shielding property against the light and disposed around the wire bonding pad electrode.
(13) The electronic device according to (12) above, in which the peripheral light-shielding unit covers a side surface of the opening.
(14) The electronic device according to (12) above, in which the peripheral light-shielding unit is disposed between the wire bonding pad electrode and the protective film.
(15) The electronic device according to (12) above, in which the peripheral light-shielding unit is disposed on an outer periphery of the wire bonding pad electrode.
(16) The electronic device according to (15) above, in which
   the peripheral light-shielding unit includes a dummy wiring layer in which a plurality of wires is stacked in a thickness direction of the first substrate via an insulating film, and
   a dummy wire of an nth layer (n is an integer of 1 or more) included in the dummy wiring layer and a dummy wire of the (n + m)th layer (m is an integer of 1 or more) included in the dummy wiring layer overlap with each other such that an inter-wire space of the dummy wire of the nth layer and the dummy wire of the (n + m)th layer overlap with each other in a thickness direction of the first substrate.
(17) The electronic device according to (15) above, in which
   the peripheral light-shielding unit includes
   a trench provided in the first substrate, and an embedded material embedded in the trench.
(18) An electronic device provided with:
   a first substrate including a drive circuit;
   a second substrate including a light-emitting unit driven by the drive circuit and mounted on one surface side of the first substrate; and
   a peripheral light-shielding unit having a light-shielding property against light emitted by the light-emitting unit, in which the first substrate includes
   a wire bonding pad electrode provided on one surface side of the first substrate, and
   a protective film provided on one surface side of the first substrate and provided with an opening that exposes a surface of the wire bonding pad electrode, and
   the peripheral light-shielding unit is disposed around the wire bonding pad electrode.

### REFERENCE SIGNS LIST

1 Light-emitting device
2 Imaging device
3 Control device
11 Light-emitting unit
12 Drive circuit
13 Power supply circuit
14 Light-emitting-side optical system
21 Image sensor
22 Image processing unit
23 Imaging-side optical system
31 distance measuring unit
40, 40A, 40B, 40C, 40D, 40E, 40F, 40G, 140A, 140B, 140C, 140D, 140E, 140F, 140G VCSEL mounted body (structural body)
41 LD chip
42 LDD substrate
42a Upper surface
42b Lower surface
43 Mounting substrate
44 Heat dissipation substrate
45 Correction lens holder
46 Correction lens
48 Bump electrode
50, 52 Light-shielding film
51 Through layer
53 Resin
60 Driver circuit
61 Bias circuit
62 CLK circuit
63 Temperature information generation unit
70 Pad electrode
71, 72, 73 Wiring layer
100 Distance measuring device
110 WB pad electrode
111 Thick film portion
112 Other portion
120 Protective film
121 Silicon oxide film (SiO₂ film)
122 Silicon nitride film (SiN)
130 interlayer insulating film
210 Light-shielding resin
211, 212 Sidewall
221 Opaque member
222 Antireflection film
230 Trench isolation
231 Trench
232 Embedded material
421 Substrate body
611 Well layer
612, 613 Bipolar transistor
DM4, DM5, DM64, DM7 Dummy wire
DML Dummy wiring layer
GR Guard ring
H50, H120 Opening
M1, M2, M3, M4, M5, M6, M7 Wire
s1, s2 Side surface
sp5, sp7 Inter-wire space

## Claims

1. An electronic device comprising:
a first substrate including a drive circuit;
a second substrate including a light-emitting unit driven by the drive circuit and mounted on one surface side of the first substrate; and
a light-shielding unit provided on the first substrate and configured to shield at least a part of the drive circuit from light emitted by the light-emitting unit.

2. The electronic device according to claim 1, wherein
the drive circuit includes a bias circuit that applies a current to the light-emitting unit, and
the light-shielding unit shields the bias circuit from the light.

3. The electronic device according to claim 1, wherein
the light-shielding unit includes a light-shielding film made of a material having a light-shielding property against the light and provided on one surface of the first substrate, and
the light-shielding film covers at least a part of the drive circuit.

4. The electronic device according to claim 3, wherein the light-shielding film is provided to cover a whole of the one surface of the first substrate except for a region where the second substrate is mounted.

5. The electronic device according to claim 3, wherein
the first substrate includes a wiring layer provided in a layer different from the light-shielding film in a thickness direction of the first substrate and made of a material having a light-shielding property against the light,
the drive circuit includes
a first region overlapping with the light-shielding film in the thickness direction of the first substrate, and
a second region not overlapping with the light-shielding film in the thickness direction of the first substrate, and
the wiring layer covers at least a part of the second region.

6. The electronic device according to claim 1, wherein a distance from a side surface of an outer periphery of the first substrate to the drive circuit is 500 µm or more.

7. The electronic device according to claim 1, wherein the light-shielding unit further includes a through layer that is made of a material having a light-shielding property against the light and penetrates the first substrate in a thickness direction of the first substrate.

8. The electronic device according to claim 7, wherein the through layer is provided in a ring shape along an outer periphery of the first substrate.

9. The electronic device according to claim 1, wherein the light-emitting unit includes a vertical-cavity surface-emitting laser (VCSEL).

10. The electronic device according to claim 1, wherein the light includes infrared light.

11. The electronic device according to claim 1, further comprising a lens that is disposed at a position facing the first substrate across the second substrate and on which the light is incident.

12. The electronic device according to claim 1, wherein
the first substrate includes
a wire bonding pad electrode provided on one surface side of the first substrate, and
a protective film provided on one surface side of the first substrate and provided with an opening that exposes a surface of the wire bonding pad electrode, and
the light-shielding unit includes a peripheral light-shielding unit having a light-shielding property against the light and disposed around the wire bonding pad electrode.

13. The electronic device according to claim 12, wherein the peripheral light-shielding unit covers a side surface of the opening.

14. The electronic device according to claim 12, wherein the peripheral light-shielding unit is disposed between the wire bonding pad electrode and the protective film.

15. The electronic device according to claim 12, wherein the peripheral light-shielding unit is disposed on an outer periphery of the wire bonding pad electrode.

16. The electronic device according to claim 15, wherein
the peripheral light-shielding unit includes a dummy wiring layer in which a plurality of wires is stacked in a thickness direction of the first substrate via an insulating film, and
a dummy wire of an nth layer (n is an integer of 1 or more) included in the dummy wiring layer and a dummy wire of the (n + m)th layer (m is an integer of 1 or more) included in the dummy wiring layer overlap with each other such that an inter-wire space of the dummy wire of the nth layer and the dummy wire of the (n + m)th layer overlap with each other in a thickness direction of the first substrate.

17. The electronic device according to claim 15, wherein
the peripheral light-shielding unit includes
a trench provided in the first substrate, and
an embedded material embedded in the trench.

18. An electronic device comprising:
a first substrate including a drive circuit;
a second substrate including a light-emitting unit driven by the drive circuit and mounted on one surface side of the first substrate; and
a peripheral light-shielding unit having a light-shielding property against light emitted by the light-emitting unit, wherein
the first substrate includes
a wire bonding pad electrode provided on one surface side of the first substrate, and
a protective film provided on one surface side of the first substrate and provided with an opening that exposes a surface of the wire bonding pad electrode, and
the peripheral light-shielding unit is disposed around the wire bonding pad electrode.
